# EUROPEAN PATENT SPECIFICATION

(11) **EP 2 202 782 B1**
(45) Date of publication and mention of the grant of the patent: **22.02.2012**
(21) Application number: 09015555.7
(22) Date of filing: 16.12.2009
(51) Int. Cl.: H01L 21/67

(54) **Micro-Bubble generating device**
Vorrichtung zur Erzeugung von Mikroblasen
Dispositif de génération de microbulles

(30) Priority: 25.12.2008 JP 2008330560
(43) Date of publication of application: 30.06.2010
(73) Proprietor: Siltronic AG, 81737 München (DE)
(72) Inventor: Haibara, Teruo, 743-0011 Hikari Yamaguchi (JP)
(74) Representative: Killinger, Andreas

(56) References cited:
- WO-A1-2008/087903
- JP-A- 1 008 630
- JP-A- 2000 000 447
- JP-A- 2005 093 873
- US-A1- 2006 137 719
- US-A1- 2007 223 916

## Description

### Technical field

The present invention relates to a micro-bubble generating device and a silicon wafer cleaning apparatus comprising the micro-bubble generating device.

### Background art

In recent years, in a manufacturing technology of a semi-conductor LSI using a silicon wafer, usage of the wafer having a larger diameter and finer processing technology are more needed. Furthermore, problems related to maintaining and enhancing of a product quality accompanying complication of a process and related to production cost reduction, etc. have also become necessary to be solved.

Particularly in many fields of the manufacturing technology of the semi-conductor LSI using the silicon wafer, so-called a wet treatment process including treatments by means of various types of solutions has become an essential process. A particularly important process among such wet treatment processes is a cleaning process and an etching process, etc. In these wet treatment processes conventionally, improvements are piling up mainly in selecting of a solution type, a density, a treatment temperature, a time frame, etc. (For example, see Non-Patent Document 1). However, these conventional technologies were not enough to fill requests accompanying a necessity for further fine processing technologies in recent years, a complication of process, a high cleanliness, and a cost reduction. Furthermore, in recent years, a treatment of dilute chemical cleaning and chemical-solution-less cleaning, etc. has been looked forward to due to the requests for tightening of environmental protection measures and the cost reduction of a waste liquid treatment.

Research and development which apply micro-bubbles to a semi-conductor cleaning have been promoted in recent years (for example, see Patent Document 1). However, in the conventional cleaning apparatus using micro-bubbles, since a nozzle of a micro-bubble generating device which generates micro-bubble is provided in a bottom of a cleaning bath, and the micro-bubbles generating device takes a large space in the cleaning bath, the micro-bubble generating device became obstructive on the occasion of installation of other devices, and the installation of the device took time and effort. In order to solve this inconvenience, there is a cleaning apparatus in which a buffer tank is provided apart from the cleaning bath, and the micro-bubble generating device is provided in this buffer tank. However, this cleaning apparatus needed a larger installing space. Accordingly, an inline-disposition in which the micro-bubble generating device is disposed in a conduit for circulating a cleaning fluid in the cleaning bath is preferred, and conventionally, there was a cleaning apparatus having the inline-disposed micro-bubble generating device. JP 200 000447 describes a swirling type fine bobble generator.
[Non-Patent Document 1] Tsuyoshi Hattori "New Edition of Cleaning Technology of Silicon Wafer Surface" Realyze Science & Engineering (2000)
[Patent Document 1] Japanese Unexamined Patent Application Publication No.2008-103701

### Disclosure of the invention

### Problems to be solved by the invention

However, if a micro-bubble generating device was installed in a narrow conduit, the micro-bubble coalesced at around the nozzle of the micro-bubble generating device, and the bubble size was made large. Particularly, in the case of the micro-bubble generating device generating a vortex flow, the bubble was brought together in the center of the conduit by a Coanda effect due to the vortex flow, and the bubble size was made larger. Accordingly, in the conventional cleaning apparatus, there was a problem that generation efficiency of the micro-bubbles decreased and cleaning performance of the silicon wafer was made to be low.

An object of the present invention is to provide a micro-bubble generating device and a silicon wafer cleaning apparatus which can enhance the generation efficiency of the micro-bubbles and can enhance the cleaning performance of the silicon wafer.

### Means for solving the problems

In order to achieve the above objects, a micro-bubble generating device according to the present invention comprises the technical features disclosed in independent claim 1.

Preferably, the micro-bubble generating mechanism and the tube part are connected to the widening section so that a flow passage axis of the micro-bubble in the widening section and the flow passage axis of the micro-bubble in the tube part are extended mutually in the same direction.

More preferably, a flowing direction of the micro-bubble in the widening section and the flowing direction of the micro-bubble in the tube part are mutually reverse.

Also preferably, the micro-bubble generating mechanism and the tube part are connected to the widening section so that the flow passage axis of the micro-bubble in the widening section and the flow passage axis of the micro-bubble in the tube part cross mutually.

More preferably, the micro-bubble generating mechanism and the tube part are connected to the widening section so that the flow passage axis in the widening section and the flow passage axis in the tube part are mutually orthogonal.

Preferably, the micro-bubble generating mechanism is connected to the widening section so that the nozzle deviates from a flow-passage-axis line of the micro-bubble in the tube part.

Also preferably, the widening section has a circular flow passage cross section.

Also preferably, the tube part is provided near the nozzle in the widening section.

A silicon wafer cleaning apparatus according to the present invention is the silicon wafer cleaning apparatus provided with the micro-bubble generating device mentioned above and cleans a silicon wafer, and comprises:
a cleaning bath accommodating the silicon wafer as a object to be cleaned and storing a cleaning fluid; and
a pump device having a pump and a conduit circulating the cleaning fluid in the cleaning bath, wherein
the micro-bubble generating device is provided in the conduit of the pump device.

### Effects of the invention

In the micro-bubble generating device according to the present invention, since the micro-bubble generating mechanism generating the micro-bubble is connected to the widening section having the larger flow passage sectional area of the micro-bubble than that of the tube part in the leading conduit for leading the generated micro-bubble, the micro-bubble spouted from the nozzle of the micro-bubble generating device disperses in the widening section without interfering mutually. Accordingly, it becomes possible that the generated micro-bubble is prevented from coalescing mutually to become a bubble of large size of which a cleaning effect is low as is conventional, and the generated micro-bubble maintains the bubble size and stabilizes in the widening section, and the micro-bubble with a small size which is high in the cleaning effect can be supplied outside through the tube part. Thus, in the micro-bubble generating device according to the present invention, the micro-bubble with the small size which is high in the cleaning effect can be supplied outside, the generation efficiency of the micro-bubble can be enhanced, and the cleaning performance can be enhanced.

Further, the micro-bubble generating device according to the present invention is simple in the structure thereof, can make a device miniaturized, and can enhance the flexibility of the disposition thereof in an applicable devices, for example, a cleaning apparatus of the silicon wafer.

Furthermore, in the silicon wafer cleaning apparatus according to the present invention, the cleaning performance can be enhanced. Further, the apparatus can be miniaturized and the flexibility of the apparatus design can be enhanced.

### Best models for carrying out the invention

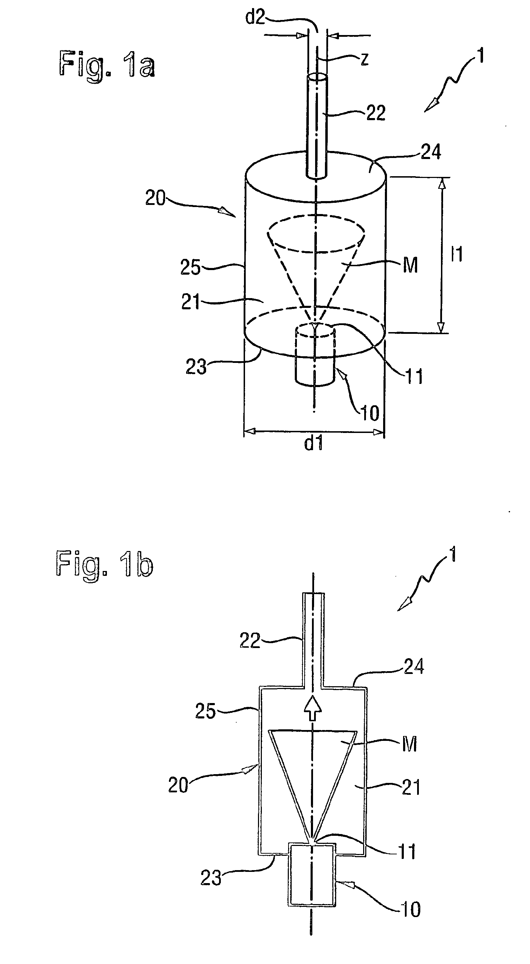

Hereinafter, embodiments according to the present invention will be described in detail with reference to figures. FIGs. 1A and 1B illustrate outline configurations of a micro-bubble generating device according to a first embodiment of the present invention, FIG. 1A is a perspective view and FIG. 1B is a front view.

As illustrated in FIGs. 1A and 1B, the micro-bubble generating device 1 according to the first embodiment of the present invention is provided with a micro-bubble generating mechanism 10 which generates a micro-bubble M, and a leading conduit 20 for leading the micro-bubble M generated by the micro-bubble generating mechanism 10 outside.

The micro-bubble generating mechanism 10 is provided with a nozzle 11 for spouting the generated micro-bubble outside. The micro-bubble generating mechanism 10, to which a fluid and a gas are supplied, spouts a fine bubble having a diameter in µm order together with the fluid. As for the micro-bubble generating mechanism 10, one which is accompanied by a flow of the fluid when the micro-bubble is generated is preferable. For example, preferable are those such as a swirling liquid flow type, a static mixer type, an ejector type, a cavitation type, a venturi type, the combination of a centrifugal pump and a swirling flow type micro-bubble generator, and one using a pressure dissolving type micro-bubble generating method. This is because the fluid containing the generated micro-bubble needs to be carried to a cleaning bath in an after-mentioned silicon wafer cleaning apparatus, and in the case of that the micro-bubble generation is accompanied by the flow of the fluid, an additional transport device or the like for carrying the micro-bubble to the cleaning bath can be omitted. However, the micro-bubble generating mechanism 10 may be one which is not accompanied by the flow of the fluid in generating the micro-bubble, and may be one in which the fluid is standing still. In this case, in the after-mentioned silicon wafer cleaning apparatus, a transport device for carrying the fluid containing the micro-bubble to the cleaning bath will be needed. As the micro-bubble generating mechanism 10 which is not accompanied by the flow of the fluid in generating the micro-bubble and in which the fluid is standing still, there are a fine pores type, a rotating type, an ultrasonic type, a steam condensation type and one using an electrolysis-type micro-bubble generating method.

The leading conduit 20 is provided with a widening section 21 and a tube part 22. The widening section 21 and the tube part 22 are connected to and communicate mutually in the leading conduit 20. The micro-bubble generating mechanism 10 which is connected to the widening section 21 spouts the micro-bubble M expanding from the nozzle 11 into the widening section 21 in a conical shape with an axis Z as a central axis.

The widening section 21 which is a hollow cylinder form with the axis Z as the central axis has base surfaces 23 and 24 and a cylindrical peripheral surface 25, and is communicating with the nozzle 11 of the micro-bubble generating mechanism 10 via one base surface 23 of the widening section 21 and is communicating with the tube part 22 via the other base surface 24. The nozzle 11 of the micro-bubble generating mechanism 10 is a cylindrical opening with the axis Z as the central axis, and the tube part 22 is a cylindrical tube with the axis Z as the central axis. That is, in the micro-bubble generating device 1, a flow passage axis of the micro-bubble flowing in the widening section 21 and a flow passage axis of the micro-bubble flowing in the tube part 22 are the identical axis Z, and the micro-bubble is made to flow in the identical direction mutually.

In the leading conduit 20, an area of a flow passage cross section of the micro-bubble of the widening section 21, i.e., the area of the cross section orthogonal to the axis Z which is the flow passage axis of the micro-bubble, is larger than the area of the flow passage cross section of the micro-bubble of the tube part 22, i.e., the area of the cross section orthogonal to the axis Z which is the flow passage axis of the micro-bubble. Further, the area of the flow passage cross section of the widening section 21 is larger than the area of the cross section (flow passage cross section) orthogonal to the axis Z of the nozzle 11 of the micro-bubble generating mechanism 10. Furthermore, the area of the flow passage cross section of the widening section 21 and the length thereof in the direction of the flow passage axis Z is set up in such a magnitude as the micro-bubble spouted from the micro-bubble generating mechanism 10 can diffuse and stabilize while maintaining the bubble size.

The size of widening section 21 differs corresponding to a flow rate of the fluid supplied to the micro-bubble generating mechanism 10, a type, a density or temperature of the fluid to be supplied, a flow rate of the gas to be supplied to the micro-bubble generating mechanism 10, or a specification of the micro-bubble generating mechanism 10, or the like. As the specifications of the micro-bubble generating mechanism 10, there is a type of a generating method of the micro-bubble, a size, bubble generation efficiency or the like, for example.

For example, the diameter d1 of the flow passage cross section of the widening section 21 is 50 to 500 mm, 75 to 300 mm preferably and 100 to 200 mm more preferably. The length I1 of the widening section 21 in the axial Z direction is 50 to 500 mm, 75 to 400 mm preferably and 100 to 300 mm more preferably. The capacity of the widening section 21 is 0.1 to 50 l (liter), 0.2 to 10 l preferably and 0.5 to 5 l more preferably. A ratio of the diameter of the flow passage cross section of the widening section 21 to the diameter of the flow passage cross section of the nozzle 11 is 10 to 100 times, 15 to 80 times preferably and 20 to 60 times more preferably, in the micro-bubble generating mechanism of the type, like the swirling liquid flow type, in which the diameter of the nozzle is comparatively small and which spouts the micro-bubble in a spray state (conical shape). In the micro-bubble generating mechanism of the type, like the ejector type, in which the diameter of the nozzle is comparatively large and which spouts the micro-bubble as the shape of the nozzle, the ratio of the diameter of the flow passage cross section of the widening section 21 to the diameter of the flow passage cross section of the nozzle 11 is 1.5 to 50 times, 2 to 40 times preferably and 3 to 30 times more preferably. As for the diameter d2 of the flow passage cross section of the tube part 22, a value suitable for the flow rate of the fluid in the widening section 21 may just be selected.

It should be noted that the size of the widening section 21 is not limited to above-mentioned one, and is set up corresponding to above-mentioned specific conditions. In the case of that the diameter d1 of the widening section 21 is too small, the length 11 of widening section 21 is too short, or the capacity of the widening section 21 is too small, the generated bubble size has become large. In the case of that the diameter d1 of the widening section 21 is too large, the length 11 of the widening section 21 is too long or the capacity of the widening section 21 is too large, a wide space for installation of the micro-bubble generating device 1 will be needed, and at the same time, the fluid usage will increase. It is preferable that the size of the widening section 21 is set up while such matters are taken into considerations.

Thus, in the micro-bubble generating device 1 according to the first embodiment of the present invention, the micro-bubble generating mechanism 10 is connected to the tube part 22 having the small flow passage sectional area via the widening section 21 having the large flow passage sectional area of the leading conduit 20, and the micro-bubble generated by the micro-bubble generating mechanism 10 is spouted first into the widening section 21 in which the flow passage sectional area is large. Accordingly, the spouted micro-bubble can diffuse without colliding with the conduit wall, and does not turn into the bubble with a large size by interfering mutually, and can diffuse until the stabilization thereof will be realized within the fluid in the widening section 21 while maintaining the same small bubble size as the size at the time of spouting. Accordingly, the micro-bubble which maintains the same small bubble size as the size at the time of spouting and which has a high cleaning effect can be supplied from the widening section 21 to the tube part 22, and the micro-bubble having the small bubble size can be led outside.

The micro-bubble generating device 1 is composed of the micro-bubble generating mechanism 10 and the leading conduit 20 having the widening section 21 and the tube part 22, and is simple in the configuration thereof.

Thus, the micro-bubble generating device 1 according to the first embodiment of the present invention can provide outside the micro-bubble of the small bubble size having the high cleaning effect. Further, the micro-bubble generating device 1 is simple in the structure, and to thereby enable a device to be miniaturized.

It should be noted that, in the micro-bubble generating device 1 according to the present embodiment, although the shape of the widening section 21 is made to be the hollow cylinder type, the shape of the widening section 21 is not limited to this. For example, the widening section 21 may be a hollow rectangular parallelepiped type.

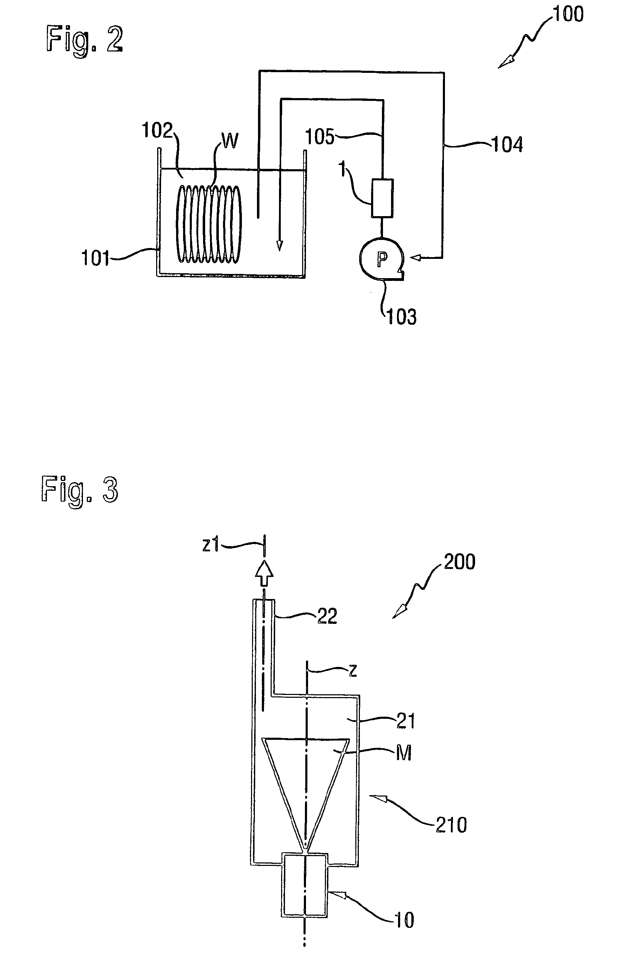

Subsequently, a silicon wafer cleaning apparatus provided with the micro-bubble generating device 1 according to the first embodiment of the present invention will be described. FIG. 2 illustrates an outline configuration of the silicon wafer cleaning apparatus provided with the micro-bubble generating device 1.

As illustrated in FIG. 2, the silicon wafer cleaning apparatus 100 is provided with a cleaning bath 101 in which a cleaning fluid 102 is stored, a pump 103 and conduits 104,105 for circulating the cleaning fluid 102 in the cleaning bath 101. The pump 103 sucks the cleaning fluid 102 from the cleaning bath 101 via the conduit 104, and supplies the cleaning fluid 102 to the cleaning bath 101 via the conduit 105. The silicon wafer cleaning apparatus 100 is provided with the micro-bubble generating device 1. The micro-bubble generating device 1 is provided in a midway of the conduit 105.

In the following, a cleaning treatment of the silicon wafer W in the silicon wafer cleaning apparatus 100 will be described.

For example, a plurality of silicon wafers W cut from a single crystal silicon ingot are disposed in a holder (not shown) in a manner that surfaces of the wafers face mutually with equal intervals, and are disposed in the cleaning bath 101 and then soaked in the cleaning fluid 102 stored in the cleaning bath 101. Subsequently, the pump 103 is operated and the cleaning fluid 102 is circulated between the cleaning bath 101 and the conduits 104, 105. Further, the micro-bubble generating device 1 is operated, the micro-bubble is generated in the circulated cleaning fluid 102 by the micro-bubble generating mechanism 10, the micro-bubble is spouted into the widening section 21 of the leading conduit 20 via the nozzle 11 and the micro-bubble is stabilized. Then, the cleaning fluid 102 including the stabilized micro-bubble having the small bubble size is led into the conduit 105 via the tube part 22, and the micro-bubble is supplied into the cleaning bath 101. In the cleaning bath 101, the cleaning fluid 102 is filled with the micro-bubble, and the silicon wafer W is cleaned by the circulated cleaning fluid 102 including the micro-bubble.

In the silicon wafer cleaning apparatus 100 provided with the micro-bubble generating device 1 according to the first embodiment of the present invention mentioned above, since the micro-bubble of the small bubble size having the high cleaning effect is supplied in the cleaning bath 101, therefore, the detergency thereof is high, whereby the silicon wafer W can be cleaned with a high cleaning degree, and the cleaning performance for the silicon wafer is enhanced.

Since the micro-bubble generating device 1 is small as mentioned above, the flexibility of a disposing position is high in the silicon wafer cleaning apparatus 100, and the design flexibility of the silicon wafer cleaning apparatus 100 can be enhanced. Further, the silicon wafer cleaning apparatus 100 can be miniaturized, whereby usage and movement thereof can be facilitated, and handling thereof can be facilitated.

Subsequently, other embodiments of the micro-bubble generating device according to the present invention will be described. Hereinafter, only different parts from the micro-bubble generating device 1 according to the first embodiment of the present invention mentioned above will be described, the same reference symbol is given to the same part and the description will be omitted.

FIG. 3 illustrates an outline configuration of a micro-bubble generating device according to a second embodiment of the present invention. A micro-bubble generating device 200 according to the second embodiment of the present invention differs only in a structure of a leading conduit against the micro-bubble generating device 1.

As illustrated in FIG. 3, in the micro-bubble generating device 200, a leading conduit 210 differs in a connecting location of the tube part 22 on the widening section 21. In the leading conduit 210, the tube part 22 is provided in a manner that the flow passage axis z1 thereof is not the same as the flow passage axis Z of the micro-bubble M in the widening section 21 and is shifted in parallel.

In the micro-bubble generating device 1 according to the first embodiment, since the flow passage axis (axis Z) of the conduit 22 is identical to the flow passage axis (axis Z) of the micro-bubble in the widening section 21 and the inlet opening of the conduit 22 is located in the micro-bubble spouting direction of the nozzle 11 of the micro-bubble generating mechanism 10, in the case of a vortex flow being generated in the widening section 21, a passage of air is formed in the center of the vortex flow, and the bubble size of the bubble in the fluid may become large by this air. On the other hand, in the micro-bubble generating device 200 according to the second embodiment, the flow passage axis z1 of the tube part 22 is offset in parallel with the flow passage axis Z of the micro-bubble M in the widening section 21. Therefore, the generation of the vortex flow in the widening section 21 can be prevented, and the micro-bubble having small bubble size can be supplied more into the tube part 22. Particularly, the present embodiment is effective particularly in the micro-bubble generating mechanism 10 using a micro-bubble generating method in which the vortex flow is generated. The micro-bubble generating method in which the vortex flow is generated includes the swirling liquid flow type, the static mixer type, or the combination of the centrifugal pump and the swirling flow type micro-bubble generator.

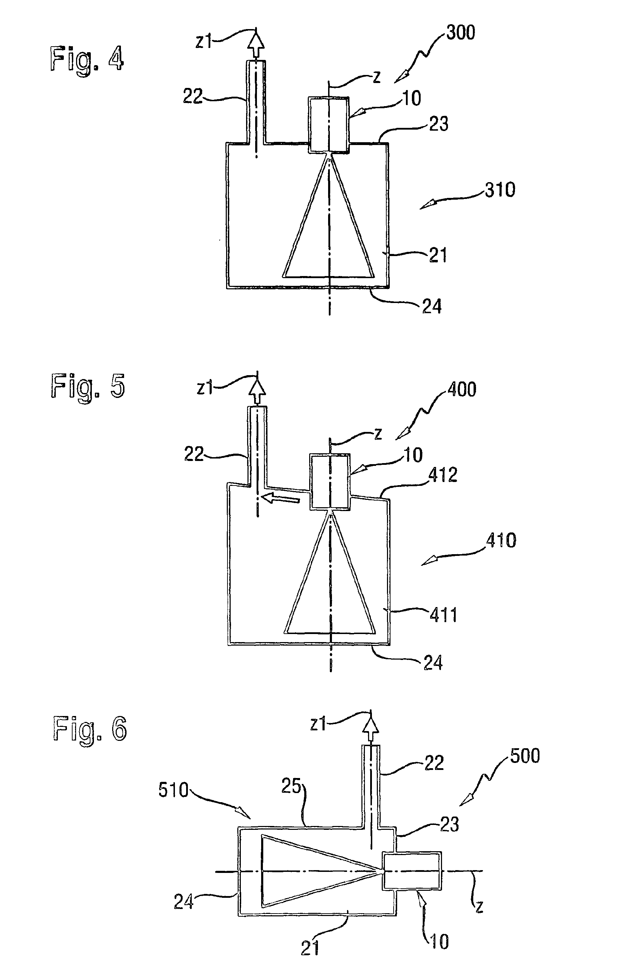

FIGs. 4 to 7 illustrate outline configurations of micro-bubble generating devices according to a third to sixth embodiment of the present invention, respectively.

A micro-bubble generating device 300 according to the third embodiment of the present invention differs only in a structure of a leading conduit against the micro-bubble generating device 1. As illustrated in FIG. 4, in the micro-bubble generating device 300, a leading conduit 310 differs in a connecting location of the tube part 22 on the widening section 21. In the leading conduit 310, the flow passage axis z1 of the tube part 22 is not identical to the flow passage axis Z of the micro-bubble M in the widening section 21 and is shifted in parallel, and the tube part 22 is connected on the base surface 23 to which the micro-bubble generating mechanism 10 is connected in the widening section 21. With this configuration, the flowing direction of the micro-bubble in the widening section 21 and the flowing direction of the micro-bubble in the tube part 22 become reverse mutually.

A micro-bubble generating device 400 according to a fourth embodiment of the present invention differs only in a structure of a leading conduit against the micro-bubble generating device 300. As illustrated in FIG. 5, in the micro-bubble generating device 400, a leading conduit 410 differs in a shape of a widening section 411. In the leading conduit 410, a base end surface 412 to which the micro-bubble generating mechanism 10 and the tube part 22 are connected is not orthogonal to the flow passage axes Z and Z1 in the widening section 411. The widening section 411 is formed in a manner that the base surface 412 gradually diverges from the base surface 24 facing the base surface 412 from the connecting location of the micro-bubble generating mechanism 10 toward the direction of the connecting location of the tube part 22.

A micro-bubble generating device 500 according to a fifth embodiment of the present invention differs only in a structure of a leading conduit against the micro-bubble generating device 1. As illustrated in FIG. 6, in the micro-bubble generating device 500, a leading conduit 510 differs in a connecting location of the tube part 22 on the widening section 21. In the leading conduit 510, the flow passage axis z1 of the tube part 22 is not identical to the flow passage axis Z of the micro-bubble M in the widening section 21, and is orthogonal to each other. That is, the tube part 22 is erected on the cylindrical peripheral surface 25 of the widening section 21. The tube part 22 is erected on a edge part at the base surface 23 side in the present embodiment. The flowing direction of the micro-bubble in the widening section 21 and the flowing direction of the micro-bubble in the tube part 22 are orthogonal to each other in this configuration. It should be noted that, although the tube part 22 is made to be connected on the side of the base surface 23 to which the micro-bubble generating mechanism 10 is connected in the widening section 21, the tube part 22 may be provided on the side of the base surface 24.

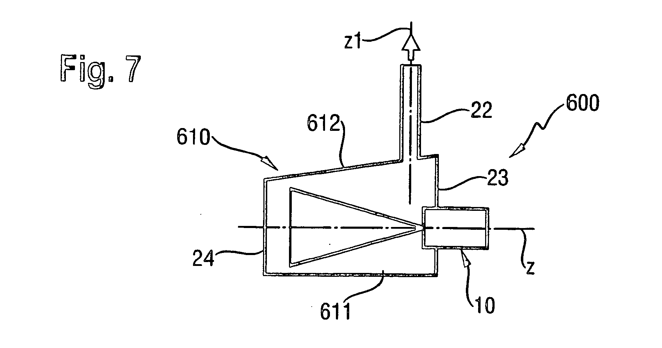

A micro-bubble generating device 600 according to a sixth embodiment of the present invention differs only in a structure of a leading conduit against the micro-bubble generating device 500. As illustrated in FIG. 7, in the micro-bubble generating device 600, a leading conduit 610 differs in a shape of a widening section 611. In the leading conduit 610, the widening section 611 is not cylindrical in a peripheral surface 612 to which the tube part 22 is connected, and is formed so that the flow passage sectional area thereof decreases from the base surface 23 to which the micro-bubble generating mechanism 10 is connected toward the base surface 24 opposed to the base surface 23. That is, as illustrated in FIG. 7, the peripheral surface 612 of the widening section 611 forms a nearly circular truncated-cone peripheral surface, and the widening section 611 is formed so that the cross section in alignment with the flow passage axis Z becomes a trapezoidal shape. This is for the sake of making the bubble hard to collect in the widening section 611.

The micro-bubble generating devices 300 to 600 according to the third to the sixth embodiments of the present invention mentioned above can achieve an effect identical to the micro-bubble generating device 200 according to the second embodiment of the present invention mentioned above.

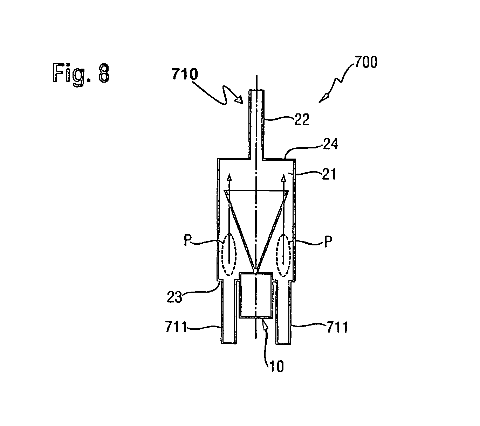

FIG. 8 illustrates an outline configuration of a micro-bubble generating device according to a seventh embodiment of the present invention. A micro-bubble generating device 700 according to the seventh embodiment of the present invention differs only in a structure of a leading conduit against the micro-bubble generating device 1.

As illustrated in FIG. 8, in the micro-bubble generating device 700, a leading conduit 710 differs in that supplying conduits 711 supplying a fluid in the widening section 21 is connected to the base surface 23 to which the micro-bubble generating mechanism 10 is connected against the widening section 21. In the present embodiment, although two supplying conduits 711 are provided at an edge part of the base surface 23, the number of the supplying conduit 711 is not limited to this.

In the micro-bubble generating device 700 according to the seventh embodiment of the present invention, since the supplying conduits 711 supplying the fluid in the widening section 21 are provided at the edge part of the base surface 23 to which the micro-bubble generating mechanism 10 is connected, in the widening section 21, therefore, the fluid in an area (area p) near the edge part of the base surface 23 in the widening section 21 is made to flow, and the fluid in the area p can be prevented from staying.

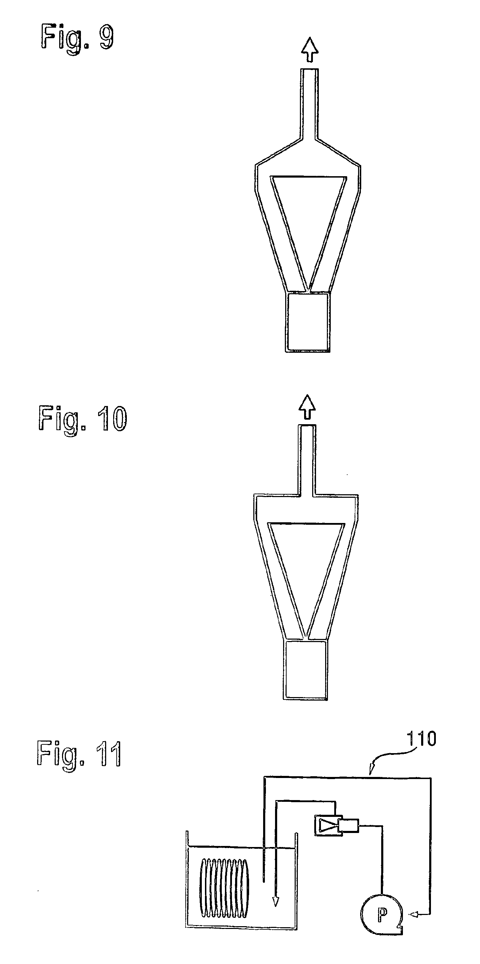

The micro-bubble generating device according to the present invention is not limited to the shape or the configuration of the micro-bubble generating device according to each embodiment of the present invention mentioned above, and may be a combination of each embodiment, for example. The shape of the widening section 21 of the micro-bubble generating device 1, as illustrated in FIG. 9, may be a hollow conical shape (circular truncated cone shape) expanding in the flowing direction of the micro-bubble with the flow passage axis Z as the central axis, and as illustrated in FIG. 10, may be a shape expanding in the flowing direction of the micro-bubble with the flow passage axis Z as the central axis, and narrowing again from a predetermined position. The tube part 22 may be disposed so that the flow passage axis z1 is not orthogonal to the flow passage axis Z of the widening section and crosses aslant the flow passage axis Z.

A direction of installation of the micro-bubble generating device according to the present invention is not limited to the direction illustrated in FIGs. 1 and 3 to 10. But it is more desirable for the tube part 22 to be in the upper side as much as possible, in order that the bubble is hard to stay in the widening section 21. For example, the direction of installation may be the direction in which the micro-bubble generating devices illustrated in FIGs. 4 and 5 have been rotated by 90 degrees to the right, and in which the micro-bubble generating devices illustrated in FIGs. 6 and 7 have been rotated by 90 degrees to the left.

There is no limit in particular also with regard to a material of the micro-bubble generating devices according to the present invention.

The micro-bubble generating devices according to the present invention may be applied to cleaning apparatuses such as a parts soaping machine, a washing machine, other than the silicon wafer cleaning apparatus. The micro-bubble generating devices according to the present invention may be installed in a bathtub, a fish preserve, a cistern of an aquarium, or a cistern for appreciation fish. In this case, for example, it is possible to be connected to a circulation passage of a circulation filtration filter. It may be provided in a midway of a hose or water pipe of a home shower.

Specifically, the micro-bubble generating devices according to the present invention are applicable in an alkaline cleaning fluid having an etching capability.

It is known that an etching rate in an alkaline cleaning fluid having an etching capability will be improved with an effect of the micro-bubble (see Patent Document 1). With the silicon wafer cleaning apparatus 100 comprising the micro-bubble generating device according to the present invention, the etching rate can be enhanced like a conventional silicon wafer cleaning apparatus with a conventional micro-bubble generating device soaked in the cleaning bath thereof.

### Example

First, a sample for evaluation was made by depositing a poly silicon layer on a mirror surface of a silicon wafer of 200mm in diameter by 1 µm approximately in thickness by CVD. Subsequently, the thickness of the poly silicon layer of the sample before cleaning was measured using NanoSpec (Nanometrics Incorporated-made).

Subsequently, as illustrated in FIG. 11, the above-mentioned sample was cleaned using the silicon wafer cleaning apparatus 110 (Example 1). The silicon wafer cleaning apparatus 110 is one in which the micro-bubble generating device 500 of the shape illustrated in FIG. 6 was used in the silicon wafer cleaning apparatus 100 of FIG. 2 as the micro-bubble generating device. As for the micro-bubble generating mechanism 10, the swirling liquid flow type (M2-MS/PTFE type made by Nanoplanet Research Institute Corporation) was used. The widening section made from quartz glass having a shape in which the diameter is 100mm and the length is 200mm was used. In a cleaning treatment thereof, specifically, as a cleaning fluid in the cleaning bath 101, an alkaline cleaning fluid having an etching capability, for example, Techniclean 200EF (principal components: an alkaline inorganic salt, an anionic surfactant, a nonionic surfactant, water) diluted 20 times with the ultrapure water was used. The used cleaning fluid was disposed of for every cleaning treatment, and the new cleaning fluid was used. In the cleaning bath 101, the above-mentioned cleaning fluid of 20 L (liter) was poured, the temperature of the cleaning fluid was set as 50 °C, and the sample was soaked for 30 minutes in this cleaning fluid. After that, the cleaned sample was taken out, and put into a 20 °C ultrapure water tank, and a rinse treatment was performed for 10 minutes. Then, this sample was dried with a spin dryer.

Subsequently, with respect to the sample of Example 1 for which the cleaning treatment was performed as mentioned above, the thickness of the poly silicon layer of the sample was measured like the measurement before cleaning.

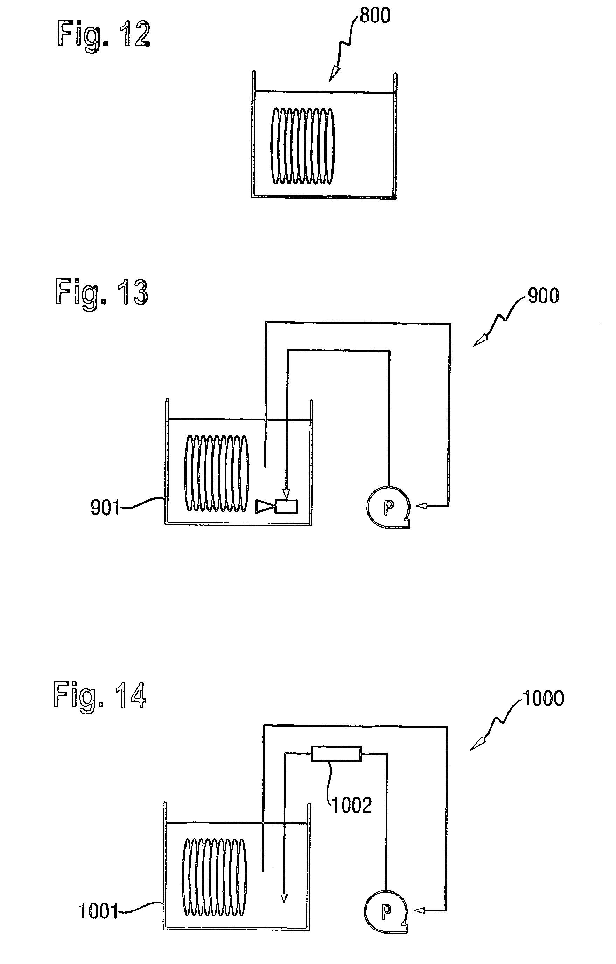

As illustrated in FIG. 12, with a silicon wafer cleaning apparatus 800 which does not have a micro-bubble generating device, the above-mentioned sample was cleaned. (Comparative Example 1) That is, the cleaning treatment in which the micro-bubble was not used and the cleaning fluid did not circulate was performed.

As illustrated in FIG. 13, with a silicon wafer cleaning apparatus 900 in which a single nozzle part of a micro-bubble generating device (M2-MS/PTFE type made by Nanoplanet Research Institute Corporation) was disposed on a base surface of a cleaning bath 901, the above-mentioned sample was cleaned.

### Comparative example 2

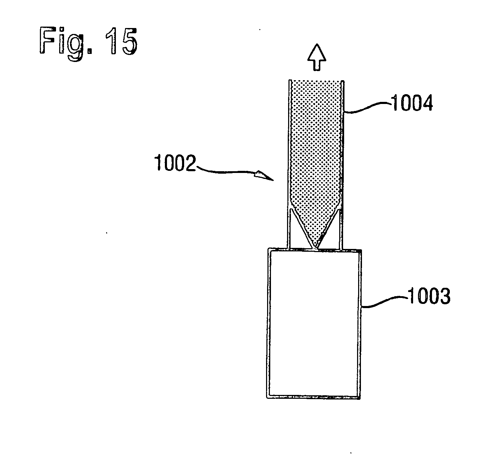

As illustrated in FIG. 14, a Teflon® ® (registered trademark of DuPont) (PFA) tube 1004 having a outer diameter of 3/4 inch and a inner diameter of 5/8 inch was connected directly to a micro-bubble nozzle of a micro-bubble generating mechanism 1003 of a micro-bubble generating device 1002 (see FIG. 15), and with a silicon wafer cleaning apparatus 1000 in which the Teflon@ tube 1004 was introduced into a cleaning bath 1001, the above-mentioned sample was cleaned. (Comparative Example 3)

The cleaning treatment in the comparative examples 1 to 3, i.e., a cleaning bath, a cleaning fluid composition, an amount of cleaning fluid, a cleaning time frame, a rinse treatment time frame, a drying method, or the like, are the same as those of the above-mentioned example 1. The sample after cleaning was measured like Example 1.

The etching rate was calculated from the thickness of the poly silicon layer before and after cleaning which was acquired by measuring the sample of Example 1 and the samples of the comparative examples 1 to 3. The results are shown in Table 1. In Table 1, Liquid Flow Amount is the flow rate of the cleaning fluid introduced into the micro-bubble generating device. Introduced Air Quantity is the flow rate of the air introduced into the micro-bubble generating device.

**[Table 1]**

| | MICRO-BUBBLE | LIQUID FLOW AMOUNT (LITER/MINUTE) | INTRODUCED AIR QUANTITY (LITER/MINUTE) | ETCHING RATE (NM/MINUTE) |
|---|---|---|---|---|
| Comparative example 1 | NONE | | | 0.84 |
| Comparative example 2 | SOAK IN BATH | 8.0 | 0.3 | 1.63 |
| Comparative example 3 | INLINE (3/4-INCH TUBE DIRECT CONNECTION) | 7.5 | 0.1 | 0.89 |
| Example 1 | INLINE (APPARATUS OF THE PRESENT INVENTION IS CONNECTED) | 7.5 | 0.1 | 1.36 |

As illustrated in Table 1, in the silicon wafer cleaning apparatus according to the present invention (Example 1), it turns out that an effect of enhancement in the etching rate equivalent to the conventional silicon wafer cleaning apparatus (Comparative example 2) in which the conventional micro-bubble generating device is soaked in the cleaning bath is acquired. That is, it turns out that the silicon wafer cleaning apparatus according to the present invention (Example 1) can generate the micro-bubble effectively.

Although the example 1 is slightly lower than the comparative example 2 in the etching rate, it is considered that this is influenced by the fact that the example 1 is smaller than the example 2 in the liquid flow amount and air introduction quantity, therefore, it is considered that the example 1 has a micro-bubble generating capability almost equivalent to the comparative example 2.

In the comparative example 3 in which the Teflon@ tube is connected directly to the micro-bubble nozzle of the micro-bubble generating mechanism, the vortex flow came out, and the large bubble was generated since the Teflon® tube was too fine. A significant enhancement in the etching rate was not found as compared with the comparative example 1 without the micro-bubble.

Thus, in the silicon wafer cleaning apparatus according to the present invention, a removing capability of various contaminants (a particle, an ion, a metal, an organic substance, or the like) on a surface of the silicon wafer can be enhanced to the extent equivalent to a conventional silicon wafer cleaning apparatus in which a conventional micro-bubble generating device is soaked in the cleaning bath.

### Brief description or the drawings

FIGs. 1A and 1B are figures illustrating an outline configuration of a micro-bubble generating device according to a first embodiment of the present invention, and FIG. 1A is a perspective view and FIG. 1B is a front view;
FIG. 2 is a figure illustrating an outline configuration of a silicon wafer cleaning apparatus provided with the micro-bubble generating device of FIG. 1;
FIG. 3 is a figure illustrating an outline configuration of a micro-bubble generating device according to a second embodiment of the present invention;
FIG. 4 is a figure illustrating an outline configuration of a micro-bubble generating device according to a third embodiment of the present invention;
FIG. 5 is a figure illustrating an outline configuration of a micro-bubble generating device according to a fourth embodiment of the present invention;
FIG. 6 is a figure illustrating an outline configuration of a micro-bubble generating device according to a fifth embodiment of the present invention;
FIG. 7 is a figure illustrating an outline configuration of a micro-bubble generating device according to a sixth embodiment of the present invention;
FIG. 8 is a figure illustrating an outline configuration of a micro-bubble generating device according to a seventh embodiment of the present invention;
FIG. 9 is a figure illustrating a modification of the micro-bubble generating device of FIG. 1;
FIG. 10 is a figure illustrating other modification of the micro-bubble generating device of FIG. 1;
FIG. 11 is a figure illustrating a silicon wafer cleaning apparatus in Example 1;
FIG. 12 is a figure illustrating a silicon wafer cleaning apparatus in Comparative Example 1;
FIG. 13 is a figure illustrating a silicon wafer cleaning apparatus in Comparative Example 2;
FIG. 14 is a figure illustrating a silicon wafer cleaning apparatus in Comparative Example 3; and
FIG. 15 is a figure illustrating a micro-bubble generating device of the silicon wafer cleaning apparatus of FIG. 14.

### Description of numerals

1, 200, 300, 400, 500, 600, 700: Micro-bubble Generating Device
10: Micro-bubble Generating Mechanism
11: Nozzle
20, 210, 310, 410, 510, 610: Leading Conduit
21, 411, 611: Widening Section
22: Tube Part
23, 24, 412: Base Surface
25, 612: Peripheral Surface
100: Silicon Wafer Cleaning Apparatus
101: Cleaning Bath
102: Cleaning Fluid
103: Pump
104, 105: Conduit
711: Supplying Conduit
Z, Z1: Axis
M: Micro-bubble
W: Silicon Wafer

## Claims

1. A micro-bubble generating device, comprising:
a micro-bubble generating mechanism 10 generating a micro-bubble , wherein the micro-bubble generating mechanism 10 is provided with a nozzle 11 which spouts the micro-bubble outside, **characterized in that** a leading conduit 20 is connected to the micro-bubble generating mechanism 10 in order to lead out the micro-bubble generated by the micro-bubble generating mechanism and the leading conduit is provided with a widening section 21 and a tube part 22 communicating mutually, whereby the area of the flow passage cross section of the widening section 21 is larger than the area of the cross section of the tube part 22 and the micro-bubble generating mechanism is connected to the widening section, whereby the size of the widening section 21 is set up such that the microbublle spouted from the nozzle 11 can diffuse in the widening section 21 while maintaining the same bubble size at the time of spouting.

2. The micro-bubble generating device according to claim 1, wherein the micro-bubble generating mechanism 10 and the tube part 22 are connected to the widening section 21 so that a flow passage axis of the micro-bubble in the widening section 21 and the flow passage axis of the micro-bubble in the tube part 22 are extended mutually in the same direction.

3. The micro-bubble generating device according to claim 1, wherein a flowing direction of the micro-bubble in the widening section 21 and the flowing direction of the micro-bubble in the tube part 22 are reverse mutually.

4. The micro-bubble generating device according to claim 1, wherein the micro-bubble generating mechanism 10 and the tube part 22 are connected to the widening section 21 so that the flow passage axis of the micro-bubble in the widening section 21 and the flow passage axis of the micro-bubble in the tube part 22 cross mutually.

5. The micro-bubble generating device according to claim 4, wherein the micro-bubble generating mechanism 10 and the tube part 22 are connected to the widening section 21 so that the flow passage axis in the widening section 21 and the flow passage axis in the tube part 22 are orthogonal mutually.

6. The micro-bubble generating device according to any one of the preceding claims, wherein the micro-bubble generating mechanism 10 is connected to the widening section 21 so that the nozzle 11 deviates from a flow-passage-axis line of the micro-bubble in the tube part 22.

7. The micro-bubble generating device according to any one of the preceding claims, wherein the widening section 21 has a circular flow passage cross section.

8. The micro-bubble generating device according to any one of the preceding claims, wherein the tube part 22 is provided near the nozzle 11 in the widening section 21.

9. A silicon wafer cleaning apparatus cleaning a silicon wafer, the apparatus being provided with the micro-bubble generating device according to any one of the preceding claims, comprising: a cleaning bath 101 accommodating the silicon wafer as a object to be cleaned and storing a cleaning fluid 102; and a pump device having a pump 103 and a conduit 104, 105 circulating the cleaning fluid 102 in the cleaning bath 101, wherein the micro-bubble generating device is provided in the conduit of the pump device.

## Patentansprüche

1. Mikroblasenerzeugungsvorrichtung, umfassend:
einen Mikroblasenerzeugungsmechanismus 10, der eine Mikroblase erzeugt, wobei der Mikroblasenerzeugungsmechanismus 10 mit einer Düse 11 versehen ist, die die Mikroblase nach außen ausstößt,
**dadurch gekennzeichnet, dass** ein Leitrohr 20 mit dem Mikroblasenerzeugungsmechanismus 10 verbunden ist, um die Mikroblase, die vom Mikroblasenerzeugungsmechanismus erzeugt ist, hinauszuführen,
und das Leitrohr mit einem sich erweiternden Abschnitt 21 und einem Rohrteil 22 versehen ist, die miteinander in Verbindung stehen, wobei die Fläche des Strömungskanalquerschnitts des sich erweiternden Abschnitts 21 größer als die Fläche des Querschnitts des Rohrteils 22 ist, und der Mikroblasenerzeugungsmechanism u s mit dem sich erweiternden Abschnitt verbunden ist, wobei die Größe des sich erweiternden Abschnitts 21 so eingerichtet ist, dass die Mikroblase, die von der Düse 11 ausgestoßen ist, im sich erweiternden Abschnitt 21 verbreiten kann, während dabei gleichzeitig dieselbe Blasengröße zur Zeit des Ausstoßens beibehalten wird.

2. Mikroblasenerzeugungsvorrichtung nach Anspruch 1, wobei der Mikroblasenerzeugungsmechanismus 10 und der Rohrteil 22 mit dem sich erweiternden Abschnitt 21 verbunden sind, so dass eine Strömungsdurchgangsachse der Mikroblase im sich erweiternden Abschnitt 21 und die Strömungsdurchgangsachse der Mikroblase im Rohrteil 22 sich wechselseitig in derselben Richtung erstrecken.

3. Mikroblasenerzeugungsvorrichtung nach Anspruch 1, wobei eine Strömungsrichtung der Mikroblase im sich erweiternden Abschnitt 21 und die Strömungsrichtung der Mikroblase im Rohrteil 22 wechselseitig entgegengesetzt sind.

4. Mikroblasenerzeugungsvorrichtung nach Anspruch 1, wobei der Mikroblasenerzeugungsmechanismus 10 und der Rohrteil 22 mit dem sich erweiternden Abschnitt 21 verbunden sind, so dass die Strömungsdurchgangsachse der Mikroblase im sich erweiternden Abschnitt 21 und die Strömungsdurchgangsachse der Mikroblase im Rohrteil 22 sich wechselseitig kreuzen.

5. Mikroblasenerzeugungsvorrichtung nach Anspruch 4, wobei der Mikroblasenerzeugungsmechanismus 10 und der Rohrteil 22 mit dem sich erweiternden Abschnitt 21 verbunden sind, so dass die Strömungsdurchgangsachse im sich erweiternden Abschnitt 21 und die Strömungsdurchgangsachse im Rohrteil 22 wechselseitig orthogonal sind.

6. Mikroblasenerzeugungsvorrichtung nach einem der vorherigen Ansprüche, wobei der Mikroblasenerzeugungsmechanismus 10 mit dem sich erweiternden Abschnitt 21 verbunden ist, so dass die Düse 11 von einer Strömungsdurchgangsachslinie der Mikroblase im Rohrteil 22 abweicht.

7. Mikroblasenerzeugungsvorrichtung nach einem der vorherigen Ansprüche, wobei der sich erweiternde Abschnitt 21 einen kreisförmigen Strömungsdurchgangsquerschnitt hat.

8. Mikroblasenerzeugungsvorrichtung nach einem der vorherigen Ansprüche, wobei der Rohrteil 22 in der Nähe der Düse 11 im sich erweiternden Abschnitt 21 vorgesehen ist.

9. Siliziumwaferreinigungsvorrichtung, die einen Siliziumwafer reinigt, wobei die Vorrichtung mit der Mikroblasenerzeugungsvorrichtung nach einem der vorherigen Ansprüche versehen ist, umfassend:
ein Reinigungsbad 101, das den Siliziumwafer als Objekt aufnimmt, das gereinigt werden soll, und
das eine Reinigungsflüssigkeit 102 enthält, und
eine Pumpvorrichtung, die eine Pumpe 103 und einen Kanal 104, 105 hat, der die Reinigungsflüssigkeit 102 im Reinigungsbad 101 umwälzt, wobei die Mikroblasenerzeugungsvorrichtung im Kanal der Pumpvorrichtung bereitgestellt ist.

## Revendications

1. Dispositif générateur de microbulle, comprenant :
un mécanisme générateur de microbulle 10 générant une microbulle, dans lequel le mécanisme générateur de microbulle 10 est muni d'une buse 11 qui expulse la microbulle vers l'extérieur, **caractérisé en ce qu'**un conduit d'acheminement 20 est raccordé au mécanisme générateur de microbulle 10 afin d'acheminer la microbulle générée par le mécanisme générateur de microbulle et **en ce que** le circuit d'acheminement est muni d'une section d'élargissement 21 et d'une partie de tube 22 communiquant mutuellement, la superficie de la section transversale du passage d'écoulement de la section d'élargissement 21 étant supérieure à la superficie de la section transversale de la partie de tube 22 et le mécanisme générateur de microbulle étant raccordé à la section d'élargissement, la taille de la section d'élargissement 21 étant définie de manière à ce que la microbulle expulsée par la buse 11 puisse diffuser dans la section d'élargissement 21 tout en conservant la même taille de bulle au moment de l'expulsion.

2. Dispositif générateur de microbulle selon la revendication 1, dans lequel le mécanisme générateur de microbulle 10 et la partie de tube 22 sont raccordés à la section d'élargissement 21 de manière à ce qu'un axe de passage d'écoulement de la microbulle dans la section d'élargissement 21 et que l'axe de passage d'écoulement de la microbulle dans la partie de tube 22 s'étendent mutuellement dans la même direction.

3. Dispositif générateur de microbulle selon la revendication 1, dans lequel une direction d'écoulement de la microbulle dans la section d'élargissement 21 et la direction d'écoulement de la microbulle dans la partie de tube 22 sont mutuellement opposées.

4. Dispositif générateur de microbulle selon la revendication 1, dans lequel le mécanisme générateur de microbulle 10 et la partie de tube 22 sont raccordés à la section d'élargissement 21 de manière à ce que l'axe de passage d'écoulement de la microbulle dans la section d'élargissement 21 et que l'axe de passage d'écoulement de la microbulle dans la partie de tube 22 se croisent mutuellement.

5. Dispositif générateur de microbulle selon la revendication 4, dans lequel le mécanisme générateur de microbulle 10 et la partie de tube 22 sont raccordés à la section d'élargissement 21 afin que l'axe de passage d'écoulement dans la section d'élargissement 21 et que l'axe de passage d'écoulement dans la partie de tube 22 soient mutuellement orthogonaux.

6. Dispositif générateur de microbulle selon l'une quelconque des revendications précédentes, dans lequel le mécanisme générateur de microbulle 10 est raccordé à la section d'élargissement 21 afin que la buse 11 s'écarte d'une ligne définie par l'axe de passage d'écoulement de la microbulle dans la partie de tube 22.

7. Dispositif générateur de microbulle selon l'une quelconque des revendications précédentes, dans lequel la section d'élargissement 21 présente une section transversale de passage d'écoulement circulaire.

8. Dispositif générateur de microbulle selon l'une quelconque des revendications précédentes, dans lequel la partie de tube 22 est disposée à proximité de la buse 11 dans la section d'élargissement 21.

9. Appareil de nettoyage de plaquettes de silicium nettoyant une plaquette de silicium, l'appareil étant muni du dispositif générateur de microbulle selon l'une quelconque des revendications précédentes, comprenant :
un bain de nettoyage 101 recevant la plaquette de silicium en tant qu'objet à nettoyer et stockant un fluide de nettoyage 102 ; un dispositif de pompage comportant une pompe 103 et un conduit 104, 105 faisant circuler le fluide de nettoyage 102 dans le bain de nettoyage 101, dans lequel le dispositif générateur de microbulle est disposé dans le conduit du dispositif de pompage.
